# EUROPÄISCHE PATENTANMELDUNG

(11) **EP 2 271 191 A1**
(43) Veröffentlichungstag der Anmeldung: **05.01.2011**
(21) Anmeldenummer: 10006659.6
(22) Anmeldetag: 27.06.2010
(51) Int. Cl.: H05K 1/18, H05K 3/46

(54) **Eingebetteter Sandwich-Hybridschaltkreis**

(30) Priorität: 01.07.2009 DE 202009009087 U
(71) Anmelder: Aizo AG, 35578 Wetzlar (DE)
(72) Erfinder: Beck, Wilfried, 35578 Wetzlar (DE); Kemmler, Wolfgang, 35578 Wetzlar (DE)

(57) **Zusammenfassung**

Die Erfindung betrifft einen eingebetteten Sandwichhybridschaltkreis, welcher zur Minimierung von Bauraum mindestens zwei zweiseitige elektrische Leiterplatten und mindestens ein elektronisches Bauelement zwischen diesen mit einem aushärtbaren Material ausfüllt

## Beschreibung

Die Erfindung betrifft einen in Sandwichart zwischen zwei Leiterplatten eingebetteten Hybridschaltkreis.

Derartige kompakte elektronische Baugruppen werden insbesondere im Rahmen von Miniaturisierungen eingesetzt.

### Stand der Technik

Stand der Technik ist, daß für die Herstellung derartiger Baugruppen entweder Interposer verwendet werden oder es werden Kavitäten in die Innenlagen einer solchen Leiterplatte gefräst. Diese werden dann beispielsweise mit Prepreg Material unter Hitze ausgegossen.

Dieser Stand der Technik ist jedoch nur schwer weiter miniaturisierbar.

### Aufgabenstellung

Aufgabe ist es daher eine weitere Miniaturisierung derartiger Bauelemente zu ermöglichen.

Gelöst wird diese Aufgabe durch die Eigenschaften der unabhängigen Ansprüche. Ausgestaltungsformen gehen aus den Unteransprüchen hervor.

Gelöst wir diese Aufgabe insbesondere durch einen Hybridschaltkreis, umfassend mindestens zwei zweiseitige (FR4) Leiterplatten, wobei im Raum zwischen diesen Leiterplatten mindestens ein elektronisches Bauelement angeordnet ist und wobei mindestens ein Teil dieses Zwischenraums mit einem isolierenden und aushärtbaren Mittel ausgefüllt ist, und wobei mindestens eines der darin angeordneten elektronischen Bauelemente von diesem Mittel umschlossen ist.

Durch dieses Konzept wird u.a. bewirkt, daß der Chip-Boden komplett entfällt, da eine der Leiterplatten diese Funktion übernimmt. Hierfür kann eine preisgünstige normale FR4 Leiterplatte verwendet werden. Vorzugsweise kommen zweiseitige Leiterplatten zum Einsatz.

Die zweiseitigen Leiterplatten ermöglichen eine dreidimensionale Verbindung von Bauelementen und helfen hierdurch die für die Verbindung von Bauelementen notwendige Oberfläche auf einer leiterplatte zu reduzieren. Darüber hinaus können durch diese Ausweitung der Verbindung von Bauelementen auf die dritte Dimension kürzere Verbindungswege zwischen den Bauelmenten reduziert werden. So kann beispielsweise Bauelement 1, welches af der Seite 1 der Leiterplatte 1 angebracht ist, mit Bauelement 2, welches beispielsweise auf der Seite 2 der Leiterplatte 2 angebracht ist, direkt z.B. mit Hilfe eines elektrisch leitenden Abstandshalters zwischen Leiterplatte 1 und 2 leitend miteinandner verbunden werden.

Auf der einen Leiterplatte können sich beispielsweise die Gold Pads für ein Chip-Anschlussbild befinden. Auf der anderen Leiterplatte können sich dann beispielsweise das Layout für die SMD Bestückung befinden. Die Bauelemente werden zunächst vorzugsweise auf die untere Leiterplatte aufgebracht, sodaß die funktionswesentlichen Bauelemente beieinander konzentriert sind und die anderen Leiterplatten Unterstützungsfunktionen für diese jeweiligen Bauelemente bereitstellen.

Durch die Einbeziehung der dritten Dimension können miteinander zu verbindende Bauelemente unmittelbar übereinander angeordnet werden und zwar bei zwei Leiterplatten bis zu vier Bauelemente unmittelbar übereinander. Mit zunehmender Anzahl von Leiterplatten kann diese zahl entsprechend gesteigert werden.

Durch die erwähnte feste Verbindung i.e. durch die so ermöglichte kürzeren Verbindungen kann darüber hinaus die EMV-Verträglichkeit optimiert werden. Derartig realisierte kürzere Verbindungen zwischen Bauelementen sind resistenter gegen externe elektromagnetische Störungen und weniger geeignet selbst elektromagnetische Störungen abzugeben.

Die aktiven Komponenten werden vorzugsweise komplett in der Leiterplatte eingekapselt. Weiterhin kann eine extrem gute elektrische und thermische Kopplung an die Anschlusspads (Klemmenpads) hergestellt werden.

Vorzugsweise kommen hierbei folgende Arbeitsschritte zum Einsatz:
- Dünnen der Wafer
- Aufbringen eines Transferlayers auf einen Wafer für das Flip Chip Verfahren und FlipChip-Montage
- Das Kleben der Bauteile mit Dispenser und Bestückungsautomaten
- Das Ausfüllen der Zwischenräume

Vorzugsweise kommen hierbei für die Zwischenräume kleine Kontaktelemente zum Einsatz, die z.B. per Pick&Place platzierbar sind. Diesen Kontaktelementen kommt einerseits die Aufgabe zu, den Abstand zu definieren und zweitens die Aufgabe beide Leiterplatten elektrisch miteinander zu verbinden. Hierbei können entweder die beiden sich gegenüberliegcnden Leiterplattenseiten miteinander elektrisch verbunden werden, oder beispielsweise die Innenseite einer ersten Leiterplatte mit der Außenseite der weiteren Leiterplatte, beispielsweise indem der elektrische Anschluß der nach außen zeigenden Fläche mit Hilfe einer Bohrung von dessen gegenüberliegender Seite aus elektrisch anschließbar ist.

Unter Berücksichtigung dieser Merkmale grenzt sich das vorgestellte Konzept in vielfacher Weise vom einfachen übereinanderordnen zweier Leiterplatten ab. Hierunter fällt u.a., daß es sich nicht um wieder austauschbare bzw. auswechselbare Einzelplatten handelt, sondern ein zusammenwirkendes Gesamtgebilde, welches nach seiner Komposition weder physisch, noch funktional voneinander trennbar ist. Im Zusammenwirken entsteht ein in ihrer Aufbaufläche erheblich reduziertes, durch das Vergießen physisch resistentes und gegen EMV unempfindliches Gesamtbauelement, welches aufgrund seiner geringen Größe selbst auf/in Lüsterklemmen Platz findet.

Wenn alle zwischen dein Leiterplatten angeordneten Halbleiter von diesem isolierenden und aushärtbaren Mittel zumindest teilweise umschlossen sind, so bewirkt dies, daß diese eingeschlossenen Komponenten vorzugsweise komplett in der Leiterplatte eingekapselt und damit vor jeglichen Umwelteinflüssen geschützt werden. Dieses isolierende und aushärtbare Mittel muss eine sehr gute Isolationsfähigkeit, einen passender Temperaturkoeffizient und eine hohe mechanische Festigkeit Außerdem muss er sich mit Leiterplattenmaterial, welches vorzugsweise ein FR4 ist, sehr gut vernetzen. Weiterhin sollte es auch gleichzeitig als Underfill für den Flipchip verwendet werden können. So kann sichergestellt werden, dass keine Luft mit eingeschlossen wird. Derartige Eigenschaften liefert vorzugsweise ein Epoxiharz.

Wenn die Halbleiter Transistoren und /oder Dioden-Dies und/oder Varistoren sind, so bewirkt dies, daß komplex aufgebaute Baugruppen auf diese weise realisiert werden können.

Wenn mindestens zwei der Halbleiter / Dies auf eine einheitliche Höhe gedünnt werden, so bewirkt dies, daß nicht das voluminöseste Bauelement den Gesamtabstand von den Leiterlatten definiert, sondern dieser Abstand und damit ein zuvor festgelegtes Maß die Gesamtausdehnungen des sich ergebenden Bauelements definieren. Eine derartige Dünnung liegt im Bereich von ca. 300µm bis ca. 50µm. Besonders bevorzugt ist eine Dünnung von um die 200 µm.

Wenn die Halbleiter mit Leitkleber auf midestens einer der beiden Leiterplatte geklebt werden, so bewirkt dies, daß die Bauteile zweiseitig zwischen zwei normale Leiterplatten eingeklebt werden können und der Zwischenraum dann in einem ,weiteren Schritt die schon verklebten Bauelemente mit einem Kunstharz ausfüllt. So wird die zweite Leiterplatte mit Leitkleber "dispensed" und auf die Komponenten der ersten Leiterplatte gepresst.

Wenn die direkten elektrischen Verbindungen zwischen den beiden Leiterplatten von elektrisch leitenden Verbindungselementen bereitgestellt werden, so bewirkt dies, daß die Bauelemente nicht auf einer einzigen Leiterplatte anzuordnen sind, sondern eben auf mehrere leiterplatten verteilt werden können, die dann wiederum übereinander angeordnet werden können. Hierdurch kann die zweidimensionale Fläche der benötigten Leiterplatten auf ein Minimum reduziert werden bzw. es kann der Umfang der verbaubaren Bauelemente auf einer vordefinierten Fläche, signifikant erhöht werden, indem von der Fläche in die dritte Dimension (Höhe) gegangen wird. Aber auch die Höhe kann wiederum durch Dünnen von Bauelementen reduziert werden.

Vorzugsweise kann hierfür zwischen den beiden Leiterplatten mit dem Abstand Definierenden Metall (insbcs. Kupfer) - Kugeln oder mit bis zu 0 Ohm Widerständen entsprechender Größe ein definierter Abstand hergestellt. Dazu werden derartige leitenden und den Abstand der leiterplatten definierenden Verbindungselemente zusammen mit den Dies ebenfalls auf die Leiterplatte geklebt.

Die Aufgabe wird darüber hinaus auch gelöst durch eine integrierte Schaltung, umfassend mindestens einen der erfindungsgemäßen Hybridschaltkreise. Dies hat den Vorteil, daß individuell bestückte Baugruppen, welche nicht nur aus einem Chip bestehen dennoch auf der Fläche einer herkömmlichen integrierten Schaltung untergebracht werden können. Auf diese Weise können individuellere Schaltungen im gängigen DIP-Kunststoffgeliäuse untergebracht werden.

Die Aufgabe wird darüber hinaus auch gelöst durch ein Leuchtmittel und/oder ein Hausgeräte umfassend mindestens einen der erfindungsgemäßen Hybridschaltkreise.

Die Aufgabe wird darüber hinaus auch gelöst durch ein Verfahren zur Herstellung eines derartigen Hybridschaltkreis, umfassend die Schritte: Verwendung von zwei Leiterplatten; Dünnen der Bauelemente auf einheitliche Höhe; Verbinden der Bauelemente zwischen diese beiden Leiterplatten. Aufkleben den Bauelemente Leitkleber auf die Leiterplatte geklebt:

Herstellen der direkten elektrischen Verbindungen zwischen den beiden Leiterplatten; Zweite Leiterplatte wird über den Komponenten der ersten Leiterplatte angeordnet und fixiert; Der Raum zwischen den beiden Leiterplatten wird ausgefüllt; Aushärten kann nun des Leiterplatten-Sandwichs; Bestücken mit den restlichen SMD Komponenten: Vergießen der Bauteilseite mit Chipmold.

## Patentansprüche

1. Hybridschaltkreis, umfassend mindestens zwei zweiseitige (FR4) Leiterplatten, wobei im Raum zwischen diesen Leiterplatten mindestens ein elektronisches Bauelement angeordnet ist und wobei mindestens ein Teil dieses Zwischenraums mit einem isolierenden und aushärtbaren Mittel ausgefüllt ist, und wobei mindestens eines der darin angeordneten elektronischen Bauelemente von diesem Mittel umschlossen ist.

2. Hybridschaltkreis nach Anspruch 1, wobei alle zwischen den Leiterplatten angeordneten Halbleiter von diesem isolierenden und aushärtbaren Mittel zumindest teilweise umschlossen sind.

3. Hybridschaltkreis nach einem der zuvor genannten Ansprüche, wobei die Halbleiter Transistoren und /oder Dioden-Dies und/oder Varistoren sind.

4. Hybridschaltkreis nach einem der zuvor genannten Ansprüche, wobei mindestens zwei der Halbleiter auf eine einheitliche Höhe gedünnt werden.

5. Hybridschaltkreis nach Anspruch 4, wobei die Dünnung zwischen 300µm und 50µm beträgt.

6. Hybridschaltkreis nach Anspruch 5, wobei die Dünnung zwischen 200µm beträgt.

7. Hybridschaltkreis nach einem der zuvor genannten Ansprüche, wobei die Halbleiter mit Leitkleber auf mindestens einer der beiden Leiterplatte geklebt werden.

8. Hybridschaltkreis nach einem der zuvor genannten Ansprüche, wobei die direkten elektrischen Verbindungen zwischen den beiden Leiterplatten von elektrisch leitenden Verbindungselementen bereitgestellt werden.

9. Integrierte Schaltung, umfassend mindestens einen Hybridschaltkreis nach einem der Ansprüche 1 bis 8.

10. Leuchtmittel und /oder Lüsterklemme, umfassend eine der Hybridschaltkreise nach einem der Ansprüche 1 bis 9.

11. Hausgerät, umfassend eine der Hybridschaltkreise nach einem der Ansprüche 1 bis 10.

12. Verfahren zur Herstellung eines derartigen Hybridschaltkreis nach einem der Ansprüche 1 bis 10, umfassend die Schritte:
• Verwendung von zwei Leiterplatten
• Dünnen der Bauelemente auf einheitliche Höhe
• Verbinden der Bauelemente zwischen diese beiden Leiterplatten
• Aufkleben der Bauelemente Leitkleber auf die Leiterplatte geklebt
• Herstellen der direkten elektrischen Verbindungen zwischen den beiden Leiterplatten
• Zweite Leiterplatte wird über den Komponenten der ersten Leiterplatte angeordnet und fixiert
• Der Raum zwischen den beiden Leiterplatten wird ausgefüllt
• Aushärten kann nun des Leiterplatten-Sandwichs
• Bestücken mit den restlichen SMD Komponenten
• Vergießen der Bauteilseite mit Chipmold
